(19) Europäisches Patentamt
European Patent Office
Office européen des brevets

(11) Publication number: **0 506 958 A1**

(12) **EUROPEAN PATENT APPLICATION published in accordance with Art. 158(3) EPC**

(21) Application number: **90915186.2**

(51) Int. Cl.5: **H01L 35/18**

(22) Date of filing: **19.10.90**

(86) International application number: **PCT/JP90/01353**

(87) International publication number: **WO 92/07387 (30.04.92 92/10)**

(43) Date of publication of application: **07.10.92 Bulletin 92/41**

(84) Designated Contracting States: **DE FR GB**

(71) Applicant: **KABUSHIKI KAISHA KOMATSU SEISAKUSHO**
**3-6, Akasaka 2-chome**
**Minato-ku Tokyo 107(JP)**

(72) Inventor: **OKUMURA, Takuji, Tech. Inst. of KK Komatsu**
**Seisakusho, 1200, Manda**
**Hiratsuka-shi, Kanagawa-Ken 254(JP)**
Inventor: **YAMASHITA, Masao, Tech. Inst. of KK Komatsu**
**Seisakusho, 1200, Manda**
**Hiratsuka-shi, Kanagawa-Ken 254(JP)**

(74) Representative: **TER MEER - MÜLLER - STEINMEISTER & PARTNER**
**Mauerkircherstrasse 45**
**W-8000 München 80(DE)**

(54) **THERMOELECTRIC MATERIAL FOR LOW-TEMPERATURE USE AND PRODUCTION THEREOF.**

(57) $\{(Bi_{100-x}Sb_x)_{100-y}E^{II}_y\}_{100-z}E^{I}_z$ (a)

A Bi-Sb base thermoelectric material having a high performance and excellent mechanical strengths prepared through the adoption of powder metallurgy techique. An alloy comprising group I, II, III and IV elements, or a foil or a powder prepared by quenching an alloy in a molten state comprising group I, II, III and IV elements at a cooling rate of $10^3$ °C/sec or more is molded and sintered under such a conduction that a thermodynamically metastable state is maintained, thereby giving a thermoelectric material having composition (a) wherein $E^I$ is a dopant comprising a group III, IV or VI element and $E^{II}$ is a group I, II or III element including transition metals.

FIG. 1

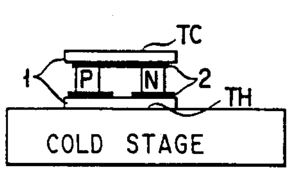


EP 0 506 958 A1

## Technical Field

The present invention concerns a Bi-Sb series thermoelectric material providing a high performance at a low temperature (77 - 200°K) and a method of manufacturing such material. More in particular, it relates to a thermoelectric material composition of a high performance Bi-Sb series alloy not obtainable so far, which is useful as a leg material for an electronic cooling module utilizing the Pertier effect and a leg material for a cold heat (source) power generation module utilizing the Seebeck effect, as well as a manufacturing method thereof.

## Background Art of the Invention

It has been generally known that Bi-Sb series alloys become n-type semiconductor having a band gap of about 0.015 eV at a low temperature region in a restricted range (for example, $Bi_{95}Sb_5$-$Bi_{80}Sb_{20}$) at 4.2°K and this exhibits an excellent Pertier effect in a low temperature region (for example, refer to Japanese Patent Publication Sho 38-15421).

In fact, the n-type Bi-Sb alloy is an intrinsic semiconductor in which electrons and positive holes are present each substantially in an identical number as carriers. However, it is considered that the alloy shows a n-type conduction since the mobility of electrons is greater than that of the positive holes (for example refer to T. Aono and T.S. Aizawa "Study on Thermal Gap of Bi-Sb Alloys", Tokyo Denki Univ.

Further, it has been reported that single crystal Bi-Sb in which group IV elements such as Sn or Pb are solid-solubilized by several hundreds of ppm shows a p type conduction in a so-called impurity region at a cryogenic temperature and the conduction type reverses to the n-type along with the elevation of temperature (for example, refer to W.Yim and A. Amith, "Solid-State Electronics", 1972, Vol. 15, p. 1141-1165).

On the other hand, the present applicant has confirmed that group III or group IV elements can be solid-solubilized by more than an equivalent amount by quenching a Bi-Sb series alloy from a molten state, by which a Bi-Sb series alloy showing p-type conduction from a cryogenic temperature to a room temperature can be obtained and has already filed a patent application (Japanese Patent Application Sho 61-035337). Further, the present applicant has previously reported, for molding and sintering of the Bi-Sb series alloy, that it is necessary to take a note on the crystal grain size and the orientation property thereof (for example, in Japanese Patent Application Sho 61-177662).

(a) It has been known that the existent Bi-Sb series single crystal n-type conduction) described above shows an excellent thermoelectric performance at a low temperature but, since current is supplied in perpendicular to the cleavaging face of a crystal, when it is put to heat cycle between a room temperature and a temperature of lower than -100°C being mounted in an electronic cooler, it involves a problem that cracking is caused to the cleavaging face due to thermal stresses, which finally leads to destruction.

(b) On the other hand, when a Bi-Sb alloy is prepared by the method of power metallurgy with an aim of providing mechanical strength in view of the foregoing problem, a Bi-Sb alloy showing excellent performance (at low temperature) as compared with the Bi-Te alloy used generally at present as the thermoelectric material, but it involves a problem that the performance is inferior to that of the single crystal Bi-Sb alloy of the identical composition (in an initial state with no cracking).

(c) Further, the Bi-Sb series alloy showing the p-type conduction up to the room temperature previously confirmed and filed as a patent application by the present applicant has a problem that there is a further room for the improvement in the thermoelectric performance since the figure of merit Z is too low to be served for practical use.

## Summary of the Invention

The present invention has been achieved in view of the foregoing situations and an object thereof is to overcome the foregoing problems and to provide a Bi-Sb series thermoelectric material having high performance and excellent mechanical strength.

Another object of the present invention is to provide a method capable of manufacturing such a Bi-Sb series thermoelectric material by using a method of powder metallurgy.

For attaining the foregoing objects, there is provided, in accordance with a first aspect of the present invention, a Bi-Sb series thermoelectric material having a composition represented by:

$$((Bi_{100-x}Sb_x)_{100-y}E^{I}_{y})_{100-z}E^{II}_{z}$$

where $E^I$ represents a group III, IV or VI element which is a dopant to be added with an aim of controlling the carrier density, $E^{II}$ represents a group I, II, III element (including transition metal) which has an effect of enlarging the band gap and/or increasing the mobility of carriers of the Bi-Sb alloy; and

$5 \leqq x \leqq 20$, $0 \leqq y \leqq 10$, $0 \leqq z \leqq 10$

In the composition described above, a Bi-Sb series thermoelectric material showing a n-type conduction or showing a p-type conduction is obtained when $E^I$ represents the VI group element or represents III, IV group element respectively.

Further, for obtaining the foregoing objects, there is provided in a second aspect according to the present invention, a method of manufacturing a thermoelectric material which comprises quenching an alloy of the aforementioned composition from a molten state at a cooling rate of greater than $10^3$/sec into a foil-like or powdery form, and molding and sintering the same under a condition keeping thermodynamically meta-stable state.

As can be understood from each of the foregoing aspects, according to the present invention, a Bi-Sb series thermoelectric material of high performance and excellent mechanical strength can be obtained by adopting a manufacturing method based on powder metallurgy.

These and other objects, aspects and advantageous features of the present invention will become apparent to those skilled in the art by explanations with reference to the following descriptions and accompanying drawings showing suitable embodiments commensurate with the principle of the present invention as examples.

## Brief Explanation of the Drawings

Fig. 1 is a schematic view for a $\pi$-type module;
Fig. 2 is a schematic constitutional view for $\Delta T$ measuring device;
Figs. 3, 5, 7, 9, 11, 13, 15, 17 and 19 are, respectively, graphs showing the changing of Seebeck constant depending on the temperature of Bi-Sb series alloys manufactured in Examples 2, 3, 4, 5, 6 and 7, Comparative Example 4 and Examples 8 and 9;
Figs. 4, 6, 8, 10, 12, 14, 16, 18 and 20 are, respectively, graphs showing the change of the electroconductivity depending on the temperature of Bi-Sb series alloys manufactured in Examples 2, 3, 4, 5, 6 and 7, Comparative Example 4 and Examples 8 and 9, respectively.

## Detailed Description of the Invention

Generally, the state of a Bi-Sb alloy is indicated by Z which is referred to as a Figure of merit defined by the following equation and the alloy has more excellent performance as Z is greater.

$Z \equiv \sigma^2.\alpha/K$

where
$\alpha$ : Seebeck constant
$\sigma$ : electroconductivity
K : heat conductivity

Since the Bi-Sb alloy is an intrinsic semiconductor, both of electrons and positive hole have a concern with $\alpha$, $\sigma$ and K. In a state where the concentration of the electron is equal with that of the positive holes, $\alpha$, $\sigma$and K are, respectively, represented by the following formulae:

$$\alpha = -\frac{k}{e}\,\frac{C-1}{C+1}\left\{2+\frac{Eg}{2kT}+\frac{3}{4}\cdot\frac{C+1}{C-1}\,\ln\left(\frac{m_e}{m_h}\right)\right\} \quad (1)$$

wherein k: Boltsman's constant, e: elementary charge, Eg: band gap, m: electron effective mass, $m_h$: positive hole effective mass, C ≡ $l_e/l_h$. $l_e$: electron mobility, $l_h$: positive hole mobility.

$\sigma$ = Ne.e.$u_e$ + $N_h$.e.$u_h$ (2)

wherein Ne: electron density and $N_h$: positive hole density,

K = Kel + Kph + Kamb (3)

wherein Kel: heat conductivity to which electrons are concerned; Kph: heat conductivity to which lattice vibrations are concerned, Kamb: heat conduction to which pair generation carriers are concerned.

In this case;

Kel = $\sigma$.L.T (4)

where L: Lorentz number

Kamb ∝ exp (-Eg/kt) (5)

As apparent from the definition for Z: figure of merit, Z can be increased by increasing $\alpha$, $\sigma$ while decreasing K. However, since $\alpha$, $\sigma$, K are functions of carrier density, mobility and band gap, it is extremely difficult to control them independently.

In this case, description will now be made to the problems described above in the prior art and a dissolution method therefor in comparison with single crystal material and sintered material having composition of $Bi_{88}$-$Sb_{12}$ as an example.

Single Crystal Material:

An ingot weight, mixed and dissolved so as to provide a composition: $Bi_{88}$-$Sb_{12}$ was applied with zone melting at a temperature gradient of 30°C/cm and a coagulation rate of 0.5 mm/cm to form a single crystal, which was cut by a wire saw, and $\alpha$, $\sigma$, K in the direction perpendicular to the C face indicated by hexagonal system of a specimen at -100°C. The results are shown in Table-1.

Sintered Material:

An ingot of $Bi_{88}$-$Sb_{12}$ was pulverized into -200 mesh and subjected to reduction in a $H_2$ atmosphere at 150°C for 2 hours and further applied with hot press at 200°C under a pressure of 1000 Kg/$cm^2$ for 30 min. $\alpha$, $\sigma$, K in the direction of applying a pressure to a specimen cut by a wire saw were measured at -100°C. The results are shown in Table-1.

Table-1

| | $\alpha$ (uV/°C) | $\sigma$ (1/Ω.cm) | K (W/d.°C) | Z (1/°C) |
|---|---|---|---|---|
| Single crystal | -100 | 7000 | $3.6 \times 10^{-2}$ | $1.94 \times 10^{-3}$ |
| Sintered material | -100 | 3400 | $3.3 \times 10^{-2}$ | $1.03 \times 10^{-3}$ |

Generally, the carrier mobility suffers from the effect of the crystal grain size. Accordingly, since $u_e$,$u_h$ are decreased, is reduced in the sintered material as compared with the single crystal. On the other hand, referring to K, while the term for Kel is decreased along with the reduction of $\sigma$ the value $\sigma$/K is reduced since the terms for Kph and Kamb do not change so much.

Since $\alpha$ does not change, it is considered that Eg, C, $m_e$, $m_h$ have no significant effect on the crystal grain size.

Accordingly, Z for the sintered material (polycrystal material) is made smaller than Z for single crystal as shown in Table-1 above.

For obtaining a large Z in the sintered material (polycrystalline body), an element having an effect of enlarging the band gap Eg and also increasing the mobility $u_e$ and $u_h$ of electrons and positive holes may be added. That is, $\alpha$is increased if Eg is enlarged in the equation (1) and Kamb is decreased if Eg is enlarged in the equation (5). Further, is increased if $u_e$, $u_h$ are increased in the equation (2). Accordingly, it is possible to increase: Z = $\alpha^2.\sigma/K$. Therefore, in the present invention, an element having an effect of enlarging the band gap and increasing the mobility of the carriers in the Bi-Sb alloy, for example, a group I, II or III element (including transition metal) is doped at a ratio of less than 10 at%.

Further, it has been generally known that Z has an extreme value also depending on the change of the carrier concentration and it may be some times necessary to add a dopant with an aim of optimizing the carrier concentration (making Z maximum) in addition to the addition of the element for enlarging Eg, $u_e$, $u_h$. In view of the above, in the present invention, a dopant for controlling the carrier concentration, for example, a group III, IV or VI element is doped by less than 10 at% as necessary.

As the condition for conducting sintering, a highest temperature for maintaining a thermodynamically meta-stable state is preferred, in which the scattering of carriers at the crystal grain boundary is reduced and $\alpha$ is increased.

In the case of $Bi_{88}$-$Sb_{12}$, the melting point is about at 300°C and the limit for the hot press temperature is 200°C (if hot press is conducted at a higher temperature, all of softened $Bi_{88}$-$Sb_{12}$ squeezed out from the gap between a punch and a sleeve and the sintered product is lost.

By adding the additive element described above, since the $Bi_{88}$-$Sb_{12}$ are reinforced by solid solubilization to improve the strength, manufacture of the sintered product is enabled even by elevating the hot press temperature to 250°C. It is considered that improvement for obtained by this is an effect of the present invention.

The present invention will now be described more specifically referring to examples and comparative examples.

Comparative Example 1

A pair of $\pi$-type modules were prepared as shown in Fig. 1 by using a BiTe device (P-N) manufactured by Komatsu Electronics Co. and when ΔTmax at Th = -100°C was measured by using a device as shown in Fig. 2, ΔTmax = 180.0°C.

In Fig. 1, are shown an AL.N ceramic plate 1, a copper plate 2 and ΔT = (TH) - (TC).

In Fig. 2, are shown a He gas cylinder 3, a liquid nitrogen vessel 4, an electromagnet 5, a controller 6, a vacuum pump 7, a thermal anchor 8, a cold stage 9, a heat radiation shield 10, a vacuum chamber 11, and a $\pi$-type module 12.

Comparative Example 2

When ΔTmax at Th = -100°C was measured for the $\pi$-type BiTe module using the device (P) manufactured by Komatsu Electronics Co. and single crystals of the $Bi_{88}$-$Sb_{12}$ (n), ΔTmax = 20.1°C. When a magnetic field of 1500 gauss was applied, ΔTmax = 23°C.

Comparative Example 3

When ΔTmax at Th = -100°C was measured for the $\pi$-type module using BiTe device (P) manufactured by Komatsu Electronics Co. and a sintered material of the $Bi_{88}$-$Sb_{12}$ (n), ΔTmax = 15.5°C. When a magnetic field of 1500 gauss was applied, ΔTmax = 18.2°C.

Example 1

An ingot having a composition of $(Bi_{88}Sb_{12})_{99.8}Ga_{0.2}$ was quenched by a single roll quenching device (100 $\phi$ roll made of Cu-Be, 800 rpm) to prepare a foil of about 30 um thickness, which was further applied with hot press at 250°C under a pressure of 1000 kg/cm$^2$. When ΔTmax at Th = -100°C was measured for a $\pi$-type module combined with a BiTe device (P) manufactured by Komatsu Electronics Co, ΔTmax = 19.9°C. When a magnetic field of 1500 gauss was applied ΔTmax = 22.8°C.

Example 2

When a sintered product was manufactured under the same conditions as those in Example 1 for compositions:
$(Bi_{88}Sb_{12})_{99.5}Ga_{0.5}$, $(Bi_{88}Sb_{12})_{99.8}Ga_{0.2}$, $(Bi_{88}Sb_{12})_{99.5}Ga_{0.5}$,$(Bi_{88}Sb_{12})_{99}Ga_1$ and $(Bi_{88}Sb_{12})_{95}Ga_5$ and temperature characteristics for $\alpha$, $\sigma$ were measured, results as shown in Figs. 3 - 4 were obtained.

Example 3

A sintered product was prepared under the same conditions as those in Example 1 for the composition: $(Bi_{88}Sb_{12})_{99.5}K_{0.5}$. The temperature characteristics for $\alpha$, $\sigma$ show the results as shown in Figs. 5 and 6.

Example 4

A sintered product was prepared under the same conditions as those in Example 1 for the composition: $(Bi_{88}Sb_{12})_{99.5}Li_{0.5}$. The temperature characteristics for $\alpha$, $\sigma$ show the results as shown in Figs. 7 and 8.

Example 5

A sintered product was prepared under the same conditions as those in Example 1 for the composition: $(Bi_{88}Sb_{12})_{99.5}Au_{0.5}$. The temperature characteristics for $\alpha$, $\sigma$ show the results as shown in Figs. 9 and 10.

Example 6

A sintered product was prepared under the same conditions as those in Example 1 for the composition: $(Bi_{88}Sb_{12})_{99.5}Ag_{0.5}$. The temperature characteristics for $\alpha$, $\sigma$ show the results as shown in Figs. 11 and 12.

Example 7

A sintered product was prepared under the same conditions as those in Example 1 for the composition: $((Bi_{88}Sb_{12})_{95}Ga_5)_{99.9}Se_{0.1}$. The temperature characteristics for $\alpha$, $\sigma$ show the results as shown in Figs. 13 and 14.

Comparative Example 4

A sintered product was prepared under the same conditions as those in Example 1 for the composition: $(Bi_{88}Sb_{12})_{90.5}Pb_{0.5}$. The temperature characteristics for $\alpha$, $\sigma$ show the results as shown in Figs. 15 and 16.

Example 8

A sintered product was prepared under the same conditions as those in Example 1 for the composition: $((Bi_{88}Sb_{12})_{95}Ga_5)_{99.5}Pb_{0.5}$. The temperature characteristics for $\alpha$, $\sigma$ show the results as shown in Figs. 1 7 and 18.

Example 9

A sintering product was prepared under the same conditions as those in Example 1 for the composition: $((Bi_{88}Sb_{12})_{95}Cu_5)_{99.5}Pb_{0.5}$. The temperature characteristics for $\alpha$, $\sigma$ show the results as shown in Figs. 19 and 20.

The Comparative Examples 1 to 3 show the performance of the existent n-type Bi-Sb single crystal and sintered body, as well as the n-type Bi-Te alloy put to practical use at present.

In the $\pi$-type module manufactured by using a p-type material with the figure of merit Zp and a n-type material with a figure of merit Zn, have the module Z as represented by: $Z = ((\sqrt{Zp} + \beta\sqrt{Zn})/1 + \beta)^2$ in which $\beta = \sigma_p K_N/\sigma_N Kp)$ and there is further a relation:
$Tmax = 1/2\ Z.Tc^2$ (Tc is a temperature at the low temperature portion of the $\pi$-type module). From the foregoings, it can be seen that the n-type BiSb single crystal has a greater $Z_N$ at -100°C as compared with the n-type BiTe material and has a further greater $Z_N$ in a magnetic field at 1500 G (magnet Pertier effect), whereas $Z_N$ of the n-type BiSb sintered material is smaller than $Z_N$ for BiTe at -100°C and is equal therewith in the magnetic field at 1500 G.

Example 1 shows that the Bi-Sb sintered material has an identical performance with the Bi-Sb single crystal by the addition of Ga by 0.2 at% (increase of Z). Further, considering the effect of Ga addition in view of Example 2, as the addition amount of Ga increases:

(1) the value for $\alpha$ is increased,

(2) the temperature dependency of $\sigma$ at about 100°K is increased (gradient for $\sigma$ vs T increases),

(3) the number of electrons is decreased (the number of positive holes is increased) when Ga (group III element) is solid-solubilized into Bi-Sb (group V element), and the number of carriers (the number of electrons) as the n-type Bi-Sb is abruptly decreased. However, decrease of $\sigma$ is small as compared with the addition amount ($\sigma$ is about 1/5 even if the Ga amount is increased by ten times).

For explaining the phenomena (1) - (3) above, it seems to be reasonable to consider that Eg is enlarged, the number of carriers is decreased and the carrier mobility is increased. That is, it is considered that $\alpha$ increases along with the decrease of the carrier number and enlargement of Eg, the gradient for $\sigma$ vs T increases in correlation with Eg, reduction of $\sigma$ is slightly suppressed by the occurrence of the reduction of the carrier number and the increase of the mobility, K decreases due to the reduction of Kamb ($\propto$ Eg) described above and, as a result, $Z = \alpha^2 . \sigma / K$ is increased.

Further, as shown in Examples 3 to 6, it has been found that the same effect can also be obtained with transition metals belonging to the group I such as K and Li or the group II such as Au or Ag, in addition to Ga.

Further, in the n-type Bi-Ab, Z can be increased by adding the n-type dopant (group VI element) to optimize the carrier number with an aim of compensating the number of electrons offset with Ga or the like (refer to Example 7).

On the other hand, for obtaining the p-type Bi-Sb, Z can be increased near 100°K by adding the p-type dopant (group III, IV element) for further increasing the number of positive holes (refer to Examples 8, 9, Comparative Example 4)

Although it is difficult to clearly explain how the additive elements contribute to the enlargement of Eg and increase of the carrier mobility, it seems to be reasonable to consider that

(1) the maximum position of the holes and the minimum position of the electrons in the band structure are deviated to enlarge Eg by the additive element, and

(2) the additive element leads to the improvement of the sinterability to prevent scattering of the carriers at the crystal grain boundary.

A dopant for controlling the carrier concentration may not necessarily be added (Example 1 or the like). Further, it has generally been known that a preferred carrier concentration of the thermoelectric material is generally about $10^{19}$ to $10^{20}$ ($1/cm^3$) and, since there is no practical meaning of adding it in excess of 10 at% (carriers by more than $10^{21}$ are generated thereby), the upper limit is defined as 10 at%.

On the other hand, since addition of mixed crystal elements for enlarging Eg and increasing the mobility in too much amount gives an undesired effect on the carrier concentration (refer to Example 2), it is judged that the amount is preferably restricted at most to about 10 at% (with the same reason as described above).

The foregoing explanations are for illustrative purpose only for preferred embodiments of the present invention, which do not limit the scope of the invention. Further various changes and modifications of the present invention will be obvious to those skilled in the art without departing the scope of the present invention.

## Claims

**1.** A Bi-Se series thermoelectric material having a composition represented by:

$$((Bi_{100-x}Sb_x)_{100-y}E^{II}_y)_{100-z}E^{I}_z$$

where $E^1$ represents a group III, IV or VI element which is a dopant to be added with an aim of controlling the carrier concentration and $E^{II}$ represents a group I, II or III element (including transition metal) which is an element having an effect of enlarging the band gap and/or increasing the mobility of carrier of the Bi-Sb alloy; $5 \leqq x \leqq 20$, $0 \leqq y \leqq 10$, $0 \leqq z \leqq 10$.

**2.** A thermoelectric material as defined in claim 1, wherein $E^I$ is a group VI element and $E^{II}$ is a group I, II or III element (including transition metal).

**3.** A thermoelectric material as defined in claim 1, wherein $E^I$ is a group III or VI element and $E^{II}$ is a group I, II or III element (including transition metal).

**4.** A method of manufacturing a thermoelectric material which comprises quenching an alloy as defined in any one of claims 1 to 3 from a molten state at a cooling rate of greater than $10^3$°C/sec into a foil-like or powdery form, and molding and sintering the same under a condition maintaining a thermodynamically meta-stable state.

FIG. 1

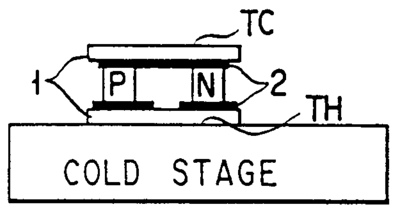


FIG. 2

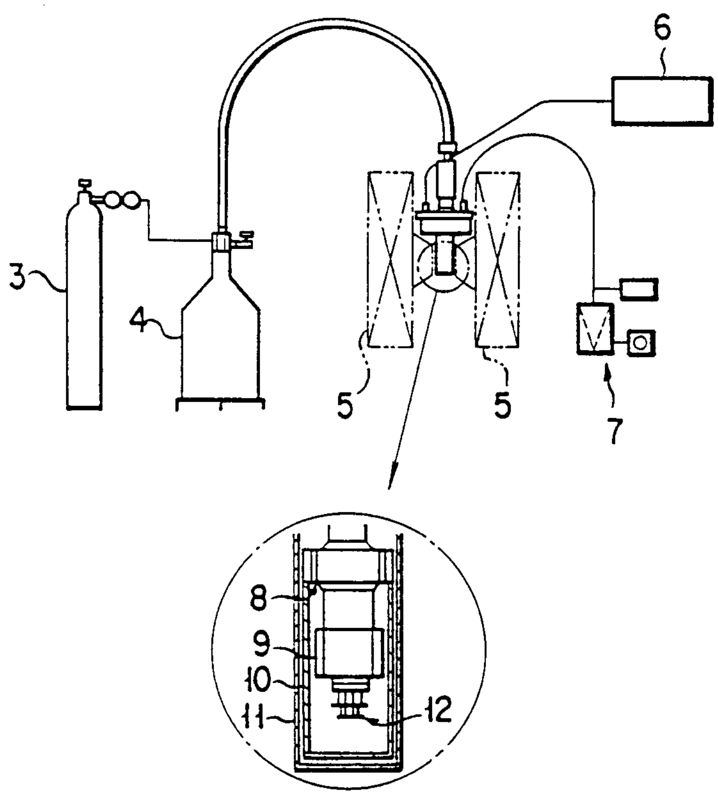

FIG. 3

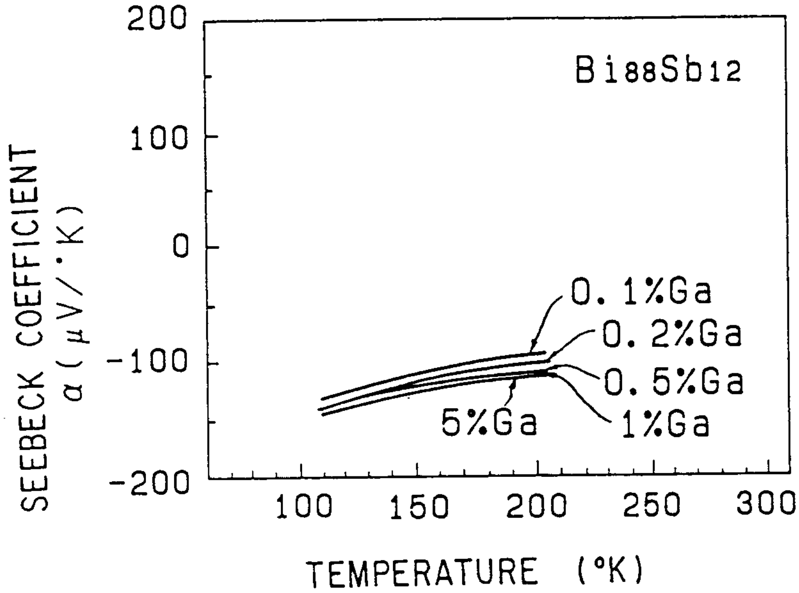
Bi88Sb12
SEEBECK COEFFICIENT
α ( μV/ ·K)
200
100
0
-100
-200
0.1%Ga
0.2%Ga
0.5%Ga
1%Ga
5%Ga
100
150
200
250
300
TEMPERATURE (°K)

FIG. 4

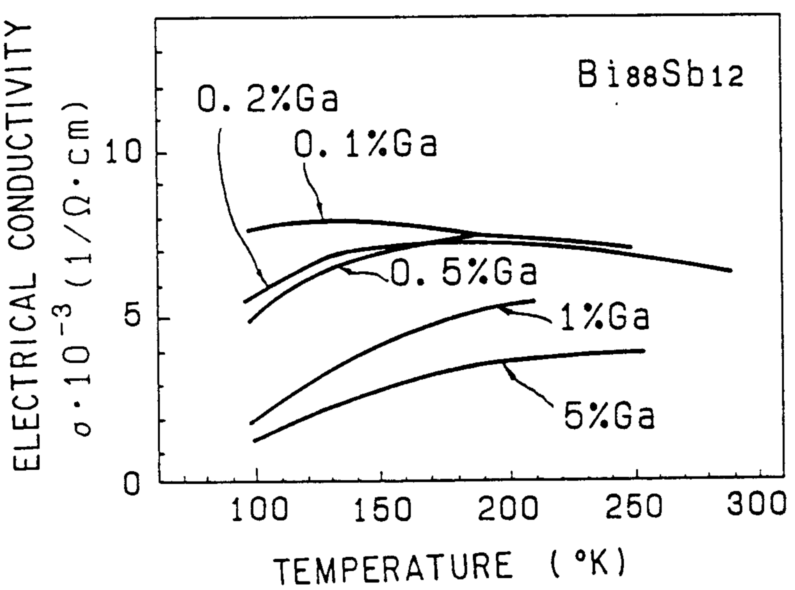
Bi88Sb12
ELECTRICAL CONDUCTIVITY
σ·10⁻³ (1/Ω·cm)
10
5
0
0.2%Ga
0.1%Ga
0.5%Ga
1%Ga
5%Ga
100
150
200
250
300
TEMPERATURE (°K)

FIG. 5

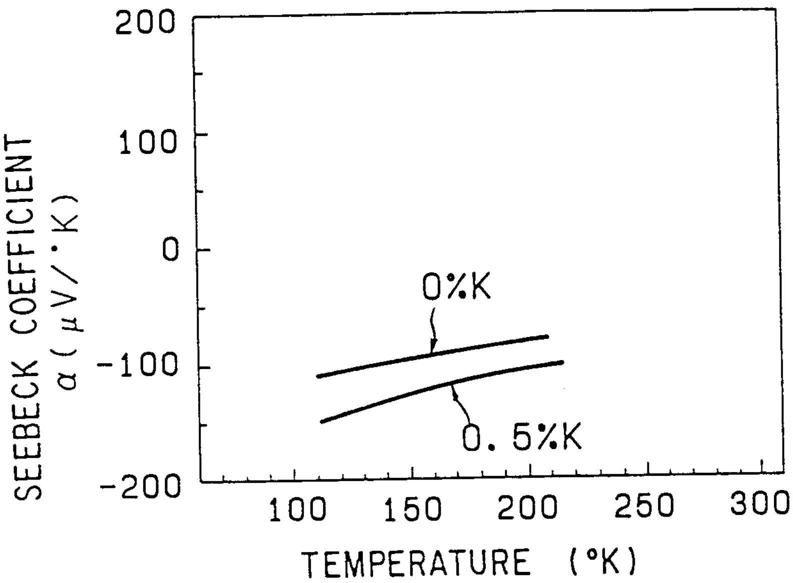
200
100
0
-100
-200
SEEBECK COEFFICIENT
α ( μV/ · K)
0%K
0. 5%K
100
150
200
250
300
TEMPERATURE (°K)

FIG. 6

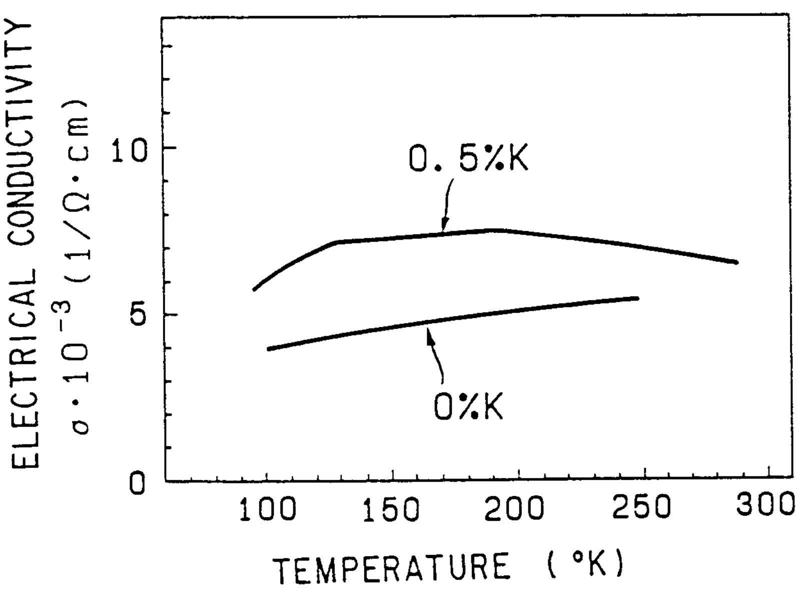
10
5
0
ELECTRICAL CONDUCTIVITY
σ · 10⁻³ (1/Ω · cm)
0. 5%K
0%K
100
150
200
250
300
TEMPERATURE ( °K)

FIG. 7

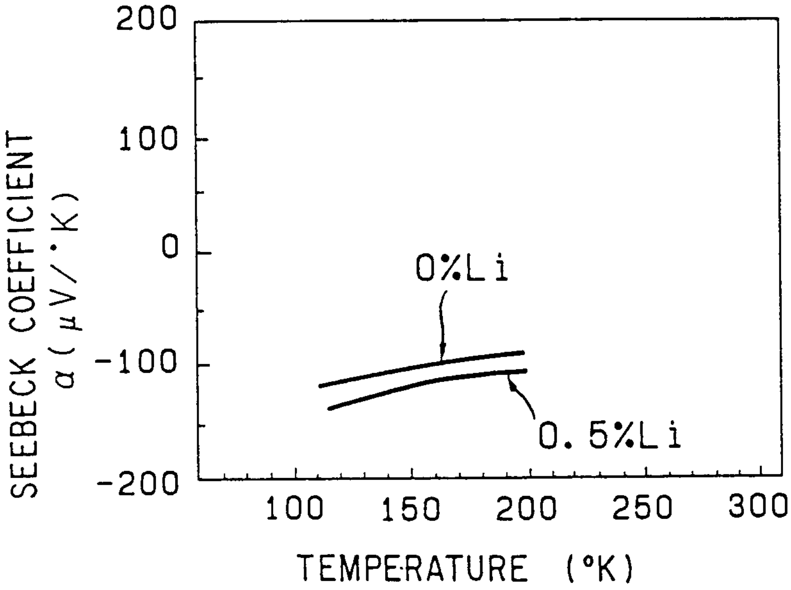
200
100
0
-100
-200
SEEBECK COEFFICIENT
α ( μV/ · K)
0%Li
0. 5%Li
100
150
200
250
300
TEMPERATURE (°K)

FIG. 8

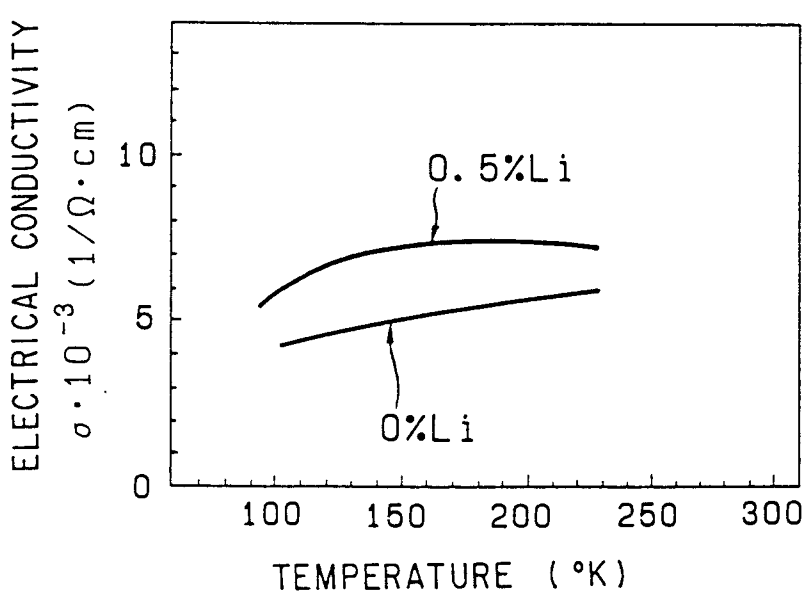
ELECTRICAL CONDUCTIVITY
σ · 10⁻³ (1/Ω · cm)
10
5
0
0. 5%Li
0%Li
100
150
200
250
300
TEMPERATURE ( °K)

FIG. 9

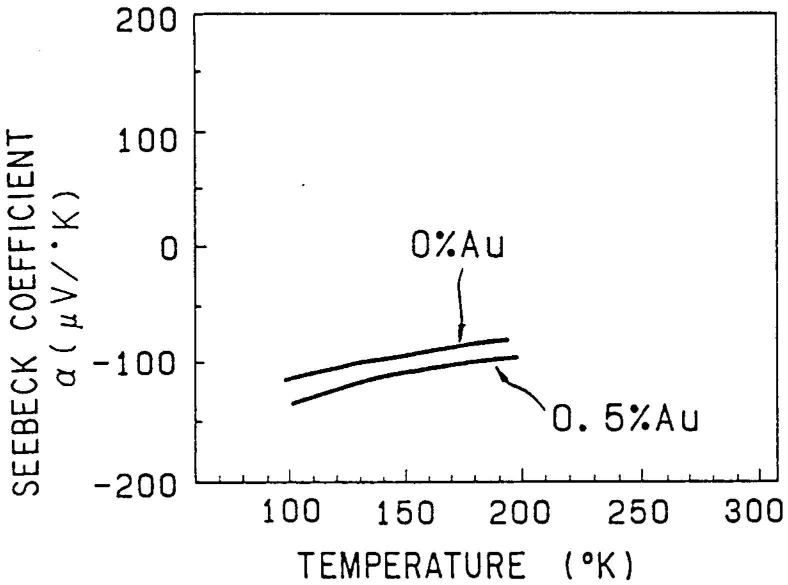
200
100
0
-100
-200
SEEBECK COEFFICIENT
α ( μV/ ° K)
0%Au
0. 5%Au
100
150
200
250
300
TEMPERATURE (°K)

FIG. 10

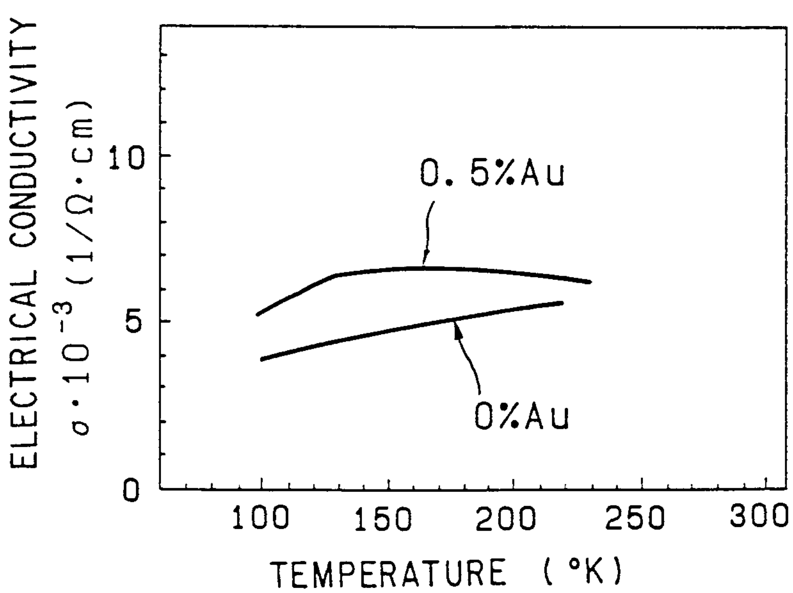
ELECTRICAL CONDUCTIVITY
σ · 10⁻³ (1/Ω · cm)
10
5
0
0. 5%Au
0%Au
100
150
200
250
300
TEMPERATURE (°K)

FIG. 11

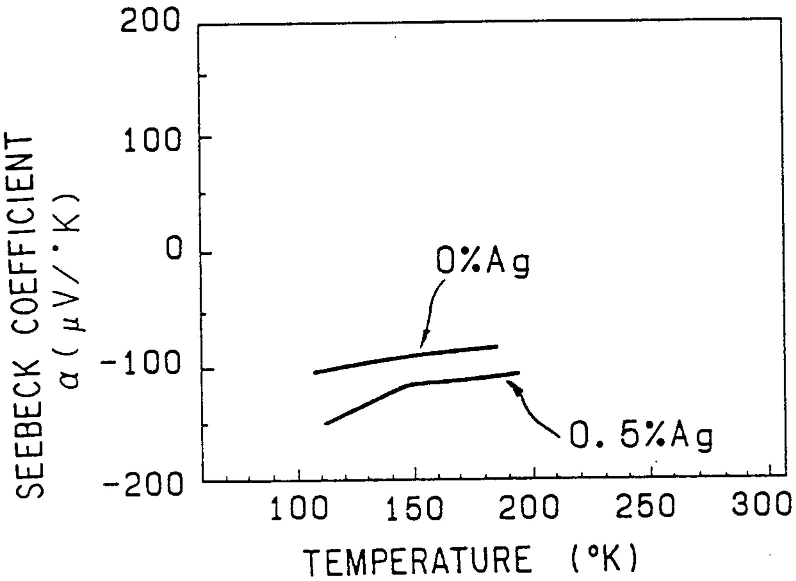
SEEBECK COEFFICIENT
α ( μV/ °K)
200
100
0
-100
-200
0%Ag
0. 5%Ag
100
150
200
250
300
TEMPERATURE (°K)

FIG. 12

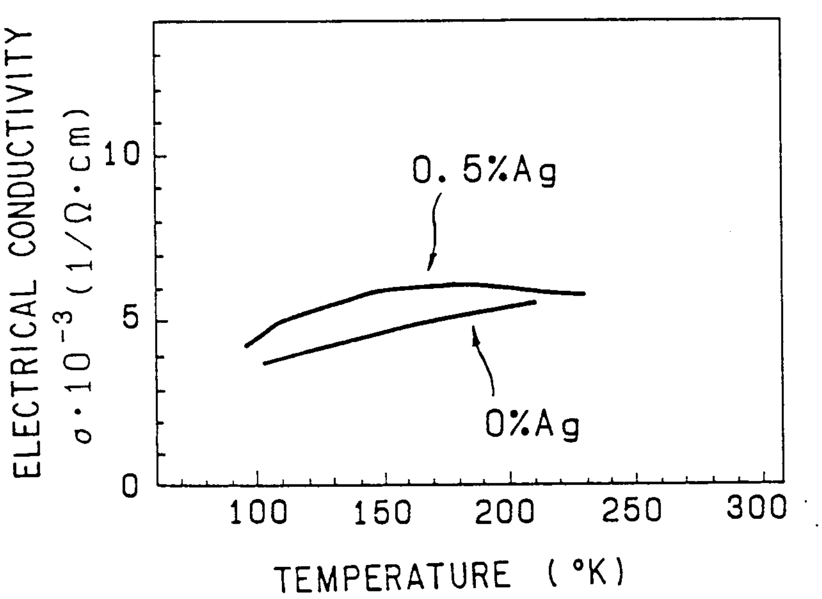
ELECTRICAL CONDUCTIVITY
σ·10⁻³ (1/Ω·cm)
10
5
0
0. 5%Ag
0%Ag
100
150
200
250
300
TEMPERATURE (°K)

FIG. 13

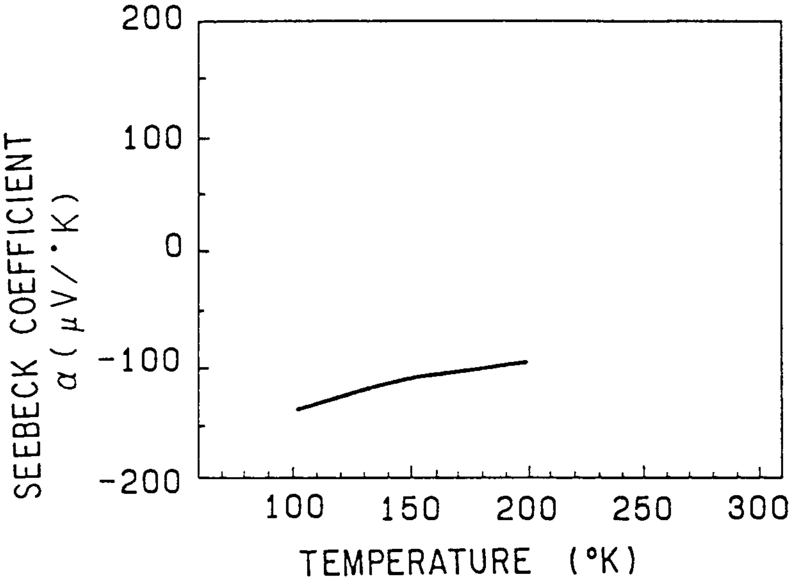
200
100
0
-100
-200
SEEBECK COEFFICIENT
α ( μV/ · K)
100
150
200
250
300
TEMPERATURE (°K)

FIG. 14

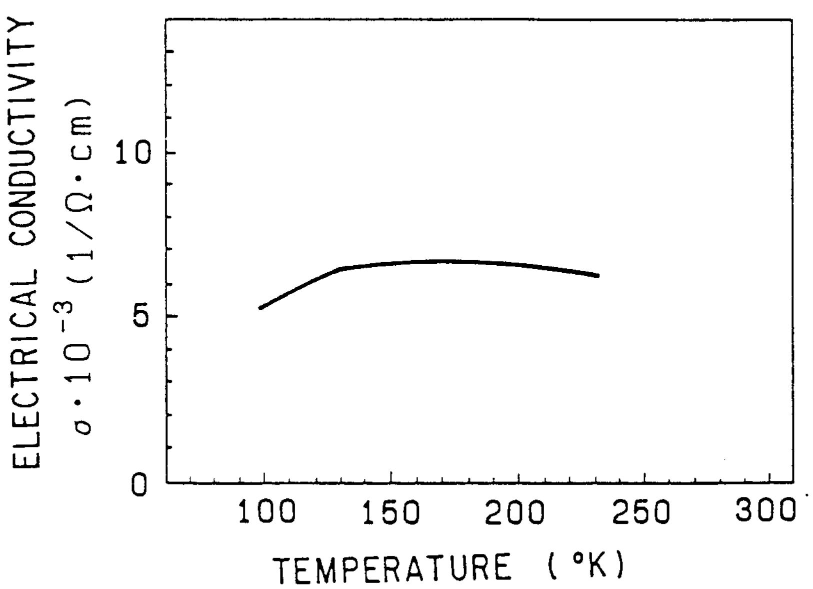
10
5
0
ELECTRICAL CONDUCTIVITY
σ · 10⁻³ (1/Ω · cm)
100
150
200
250
300
TEMPERATURE (°K)

FIG. 15

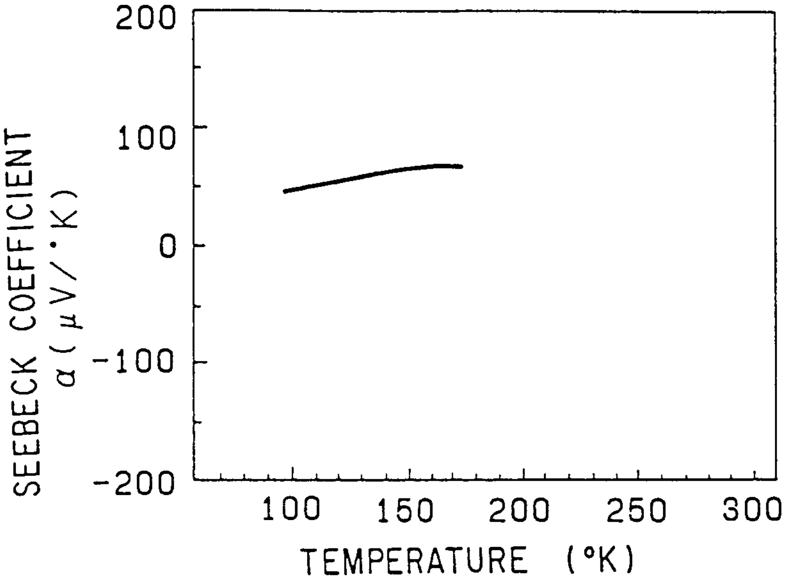
200
100
0
-100
-200
SEEBECK COEFFICIENT
α ( μV/·K )
100
150
200
250
300
TEMPERATURE (°K)

FIG. 16

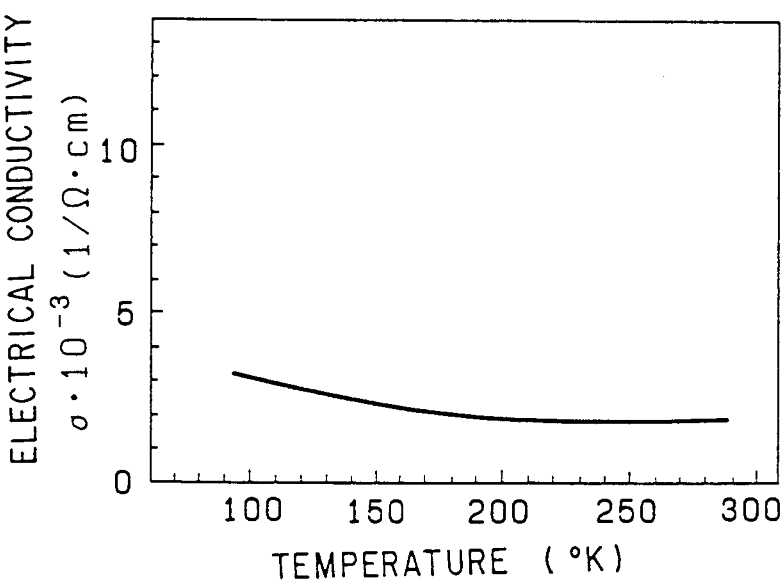
10
5
0
ELECTRICAL CONDUCTIVITY
σ·10⁻³ (1/Ω·cm)
100
150
200
250
300
TEMPERATURE (°K)

FIG. 17

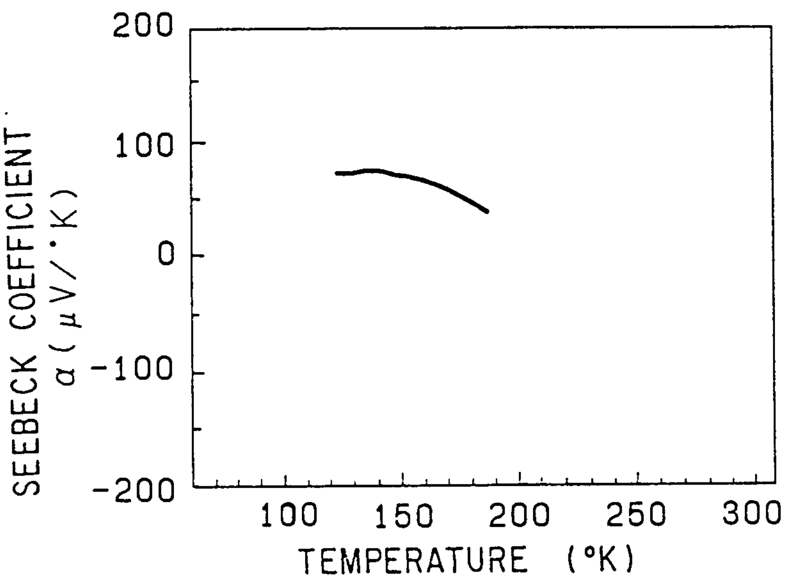
200
100
0
-100
-200
SEEBECK COEFFICIENT
α ( μV/ ·K )
100
150
200
250
300
TEMPERATURE (°K)

FIG. 18

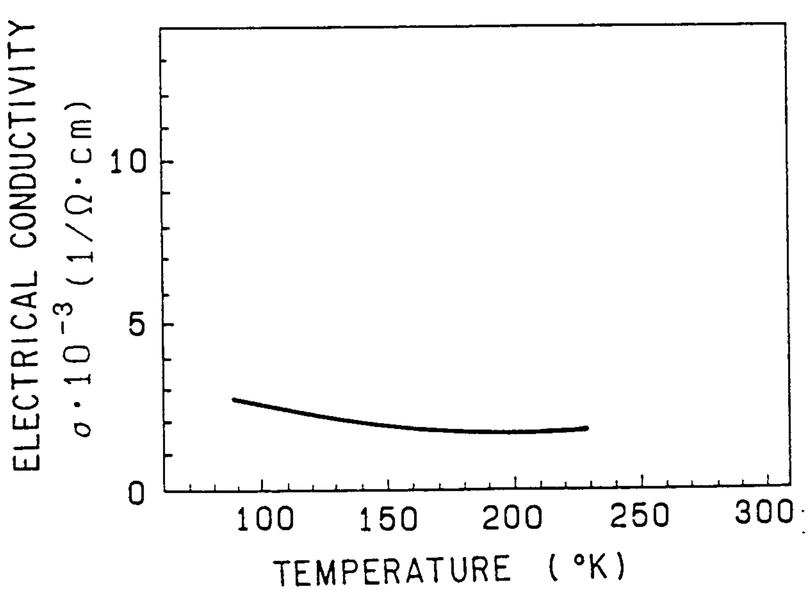
10
5
0
ELECTRICAL CONDUCTIVITY
σ·10⁻³ (1/Ω·cm)
100
150
200
250
300
TEMPERATURE ( °K)

FIG. 19

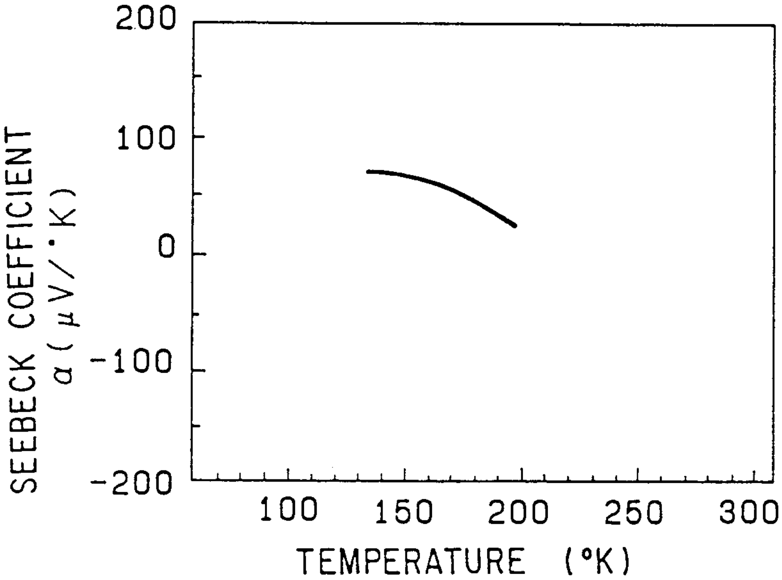
200
100
0
-100
-200
SEEBECK COEFFICIENT
α ( μV/ ·K)
100
150
200
250
300
TEMPERATURE (°K)

FIG. 20

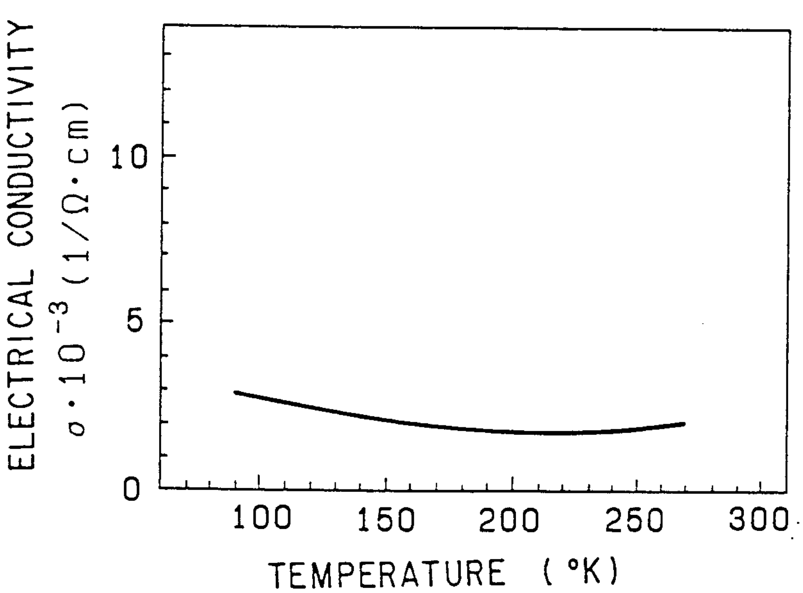
10
5
0
ELECTRICAL CONDUCTIVITY
σ · 10⁻³ (1/Ω · cm)
100
150
200
250
300
TEMPERATURE ( °K)

# INTERNATIONAL SEARCH REPORT

International Application No PCT/JP90/01353

**I. CLASSIFICATION OF SUBJECT MATTER** (if several classification symbols apply, indicate all) [6]

According to International Patent Classification (IPC) or to both National Classification and IPC

Int. $Cl^5$ H01L35/18

**II. FIELDS SEARCHED**

Minimum Documentation Searched [7]

| Classification System | Classification Symbols |
|---|---|
| IPC | H01L35/18 |

Documentation Searched other than Minimum Documentation to the Extent that such Documents are Included in the Fields Searched [8]

| | |
|---|---|
| Jitsuyo Shinan Koho | 1926 - 1990 |
| Kokai Jitsuyo Shinan Koho | 1971 - 1990 |

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| A | JP, A, 1-279724 (Nippon Mining Co., Ltd.), November 10, 1989 (10. 11. 89), (Family: none) | 1-4 |
| A | JP, A, 1-106478 (Mitsui Mining & Smelting Co., Ltd.), April 24, 1989 (24. 04. 89), (Family: none) | 1-4 |
| A | JP, B2, 44-18055 (Nippon Columbia Co., Ltd.), August 8, 1969 (08. 08. 69), (Family: none) | 1-4 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| January 8, 1991 (08. 01. 91) | January 28, 1991 (28. 01. 91) |
| **International Searching Authority** | **Signature of Authorized Officer** |
| Japanese Patent Office | |